# FASCICULE DE BREVET EUROPEEN

(11) **EP 2 342 733 B1**
(45) Date de publication et mention de la délivrance du brevet: **01.11.2017**
(21) Numéro de dépôt: 09749165.8
(22) Date de dépôt: 14.09.2009
(51) Int. Cl.: H01J 27/26, H01J 37/08, B01D 8/00

(54) **DISPOSITIF DE GÉNÉRATION D'UN FAISCEAU D'IONS AVEC PIÈGE CRYOGÉNIQUE**
EINRICHTUNG ZUR ERZEUGUNG EINES IONENSTRAHLS MIT CRYOGENFALLE
DEVICE FOR GENERATING AN ION BEAM WITH CRYOGENIC TRAP

(30) Priorité: 15.09.2008 FR 0856190; 15.09.2008 FR 0856189
(43) Date de publication de la demande: 13.07.2011
(73) Titulaire: Centre National de la Recherche Scientifique (C.N.R.S.), 75016 Paris (FR)
(72) Inventeur: GIERAK, Jacques, F-91220 Le Plessis Pate (FR); JEDE, Ralf, 58239 Schwerte (DE)
(74) Mandataire: Lavoix
(86) Numéro de dépôt international: PCT/FR2009/051720
(87) Numéro de publication internationale: WO 2010/029270

(56) Documents cités:
- WO-A-02/078036
- DE-A1- 3 404 802
- JP-A- 60 133 635
- US-A- 4 272 699
- US-B1- 6 294 862
- HORNSEY R I ET AL: "The effects of source temperature and characteristics on the optical emission from a gallium liquid metal ion source" JOURNAL OF PHYSICS D. APPLIED PHYSICS, IOP PUBLISHING, BRISTOL, GB, vol. 22, no. 5, 14 mai 1989 (1989-05-14), pages 699-704, XP020015062 ISSN: 0022-3727
- LEUNG KA-NGO: "The application and status of the radio frequency driven multi-cusp ion source (invited)" REVIEW OF SCIENTIFIC INSTRUMENTS, AIP, MELVILLE, NY, US, vol. 71, no. 2, 1 février 2000 (2000-02-01), pages 1064-1068, XP012037925 ISSN: 0034-6748

## Description

La présente invention concerne un dispositif de génération d'un faisceau d'ions comportant une source d'ions à métal liquide. Un tel dispositif de génération d'un faisceau d'ions est connu du document WO 02/078036 A2. Ce dispositif connu comporte une source d'ions située en amont d'un système d'extraction et d'accélération du faisceau d'ions et d'une chambre de travail.

On a constaté que l'utilisation du dispositif décrit dans le document WO 02/078036 A2 en combinaison avec des techniques d'injection de gaz réactifs ou précurseurs au niveau de la chambre de travail réduit notablement la durée de vie de la source d'ions à métal liquide ainsi que la stabilité du processus émissif des ions métalliques par réaction des traces résiduelles de gaz injectés avec le film de métal de la source d'ions maintenu en phase liquide. Cela est particulièrement sensible lorsque cette réaction s'opère au voisinage de la partie terminale de la source constituée d'une pointe et se manifeste généralement par des interruptions dans l'émission du faisceau d'ions et déplacement latéral du site émissif.

En effet, même une très faible proportion des molécules de gaz injectées dans la chambre de travail qui diffusent au voisinage de la source d'ions ont une très forte probabilité d'être ionisées puis ensuite d'être happées par la zone de très fort champ électrostatique régnant à l'apex de la pointe (∼10¹⁰ V/m). Le dépôt de ces molécules va modifier localement les propriétés physico-chimiques du film de métal liquide ou de la pointe support et donc perturber les propriétés d'émission initialement choisies.

Ce dépôt de molécules peut constituer une source de pollution / contamination pour :
(i) Le film de métal liquide par formation d'une barrière d'oxyde réfractaire interrompant la fonction d'apport du métal liquide basé sur un mécanisme de diffusion de surface ;
(ii) La géométrie de la pointe support par croissance de structures parasites latérales capables d'activer un site émissif au détriment du site originel.

Un but de l'invention est donc de rendre un dispositif de génération d'un faisceau d'ions comportant une source d'ions à métal liquide compatible avec les techniques d'injection de gaz dans la chambre de travail.

Ce but est atteint par un dispositif de génération d'un faisceau d'ions du type précité, caractérisé en ce que la source d'ions est entourée d'un piège cryogénique maintenu à basse température, ce piège cryogénique étant apte à piéger des espèces chimiques volatiles par condensation avant qu'elles ne puissent atteindre la source d'ions.

En entourant la source d'ions d'un piège cryogénique, on la protège de façon efficace contre l'effet des gaz injectés dans la chambre de travail au niveau de l'échantillon. Les gaz sont ainsi neutralisés par le piège cryogénique et n'agissent plus sur la source d'ions.

Le document JP 60 133 635 décrit une source d'ions cryogénique utilisant du gaz d'hydrogène comme « carburant », c'est-à-dire comme espèce d'apport à ioniser. La source comprend une pointe intégrée dans une enceinte de confinement qui a pour fonction de créer une surpression locale du gaz d'hydrogène injecté dans l'enceinte. Le gaz d'hydrogène est introduit dans l'enceinte de confinement par un tuyau d'alimentation relié à une ouverture ménagée dans l'une des parois de l'enceinte. Des chicanes sont placées à l'intérieur du tuyau qui ont pour fonction de condenser, et ainsi de piéger, des traces de gaz indésirables présentes dans le flot d'hydrogène à ioniser. Le fonctionnement de cette source requiert obligatoirement de maintenir simultanément l'ensemble constitué par la pointe et l'enceinte à très basse température afin de garantir la condensation du gaz d'hydrogène sur la pointe. Les parois froides de l'enceinte de confinement doivent être aussi proches que possible de la pointe.

Le document US 4,272,699 décrit une source d'ions par impacts d'électrons faisant partie d'un spectromètre de masse. Un flot gazeux dont la composition est à analyser est introduit d'un côté dans une chambre afin d'y être ionisé par bombardements à électrons, et le flot ionisé quitte la chambre de l'autre côté en direction d'un analyseur en masse. La chambre d'ionisation est insérée dans une chambre cryogénique servant à réduire le spectre de gaz résiduels par piégeage sur ses parois internes. L'objectif est l'amélioration du rapport signal sur bruit par condensation, et ainsi élimination, des vapeurs résiduelles en faveur du flot de gaz injecté que l'on souhaite analyser.

Suivant des modes particuliers de réalisation, le dispositif de génération d'un faisceau d'ions selon l'invention comprend une ou plusieurs des caractéristiques suivantes, prise(s) isolément ou suivant toutes les combinaisons techniquement possibles :
Le piège cryogénique est maintenu à basse température par:
   - circulation ou accumulation d'un fluide cryogénique, le fluide cryogénique étant de préférence de l'azote liquide ; ou
   - un réfrigérateur mécanique générant une faible émission de vibrations ; ou
   - un réfrigérateur électrique ;
Le piège cryogénique est maintenu à une température inférieure à 100 K ;
Le piège cryogénique comprend une gaine à deux extrémités ouvertes entourant la source d'ions ;
Le piège cryogénique comprend un tube spiralé à fluide cryogénique enroulé autour de la gaine ;
L'une des extrémités ouvertes de la gaine sert au passage du faisceau d'ions produit par la source d'ions ;
La gaine est formée par une paroi de révolution, cette paroi comprenant une première section de forme cylindrique et une deuxième section de forme tronconique ;
Une électrode d'extraction, le piège cryogénique entourant à la fois la source d'ions et l'électrode d'extraction ;
L'électrode d'extraction étant munie d'une ouverture permettant le passage du faisceau d'ions, le dispositif comprend en outre un moyen de génération d'un champ magnétique apte à générer un champ magnétique au niveau de l'ouverture de l'électrode d'extraction, le champ magnétique généré étant apte à dévier des particules chargées attirées par la source d'ions de manière à ce que ces particules chargées n'atteignent pas la source d'ions ;
Le champ magnétique généré est apte à dévier les particules chargées de telle manière qu'elles rencontrent une paroi de l'électrode d'extraction au lieu d'atteindre, en traversant l'ouverture de l'électrode d'extraction, la source d'ions ;
Le moyen de génération d'un champ magnétique est agencé au niveau de l'ouverture de l'électrode d'extraction ;
L'ouverture de l'électrode d'extraction est réalisée dans un renfoncement de l'électrode d'extraction, le moyen de génération d'un champ magnétique étant placé à l'intérieur de ce renfoncement, en bordure de ladite ouverture ;
Le moyen de génération d'un champ magnétique comprend au moins un aimant permanent ;
Le moyen de génération d'un champ magnétique est composé de deux aimants permanents placés en vis-à-vis ;
Les deux aimants permanents définissent entre eux un entrefer de préférence ajustable d'environ 2 à environ 4 mm ;
Le champ magnétique induit par les deux aimants permanents dans l'entrefer est de l'ordre de 0,1 à 1 Tesla ;
La source d'ions à métal liquide comprend une tige conductrice terminée par une pointe, un réservoir fixé à la tige et servant à accueillir une charge de métal à liquéfier, ainsi qu'un filament conducteur comportant des enroulements traversés par la pointe de la tige.

En outre l'invention concerne une installation à faisceau d'ions focalisé comprenant :
- une chambre de travail contenant un support d'échantillon et une amenée de gaz réactifs à proximité du support d'échantillon ; et
- une colonne à plusieurs étages, dont un premier étage de génération du faisceau d'ions et un deuxième étage d'orientation et de focalisation du faisceau d'ions,
installation dans laquelle le premier étage comporte un dispositif de génération d'un faisceau d'ions tel qu'énoncé ci-dessus.

L'invention sera mieux comprise à la lecture de la description qui va suivre, donnée uniquement à titre d'exemple, et faite en se référant aux dessins annexés.
La figure 1 est une vue en perspective écorchée d'une installation à faisceau d'ions focalisé selon un mode de réalisation de l'invention ;
La figure 2 est une vue en coupe longitudinale de la colonne de l'installation de la figure 1, selon les flèches I-I ;
La figure 3 est une vue de côté, partiellement en coupe, du dispositif de génération d'un faisceau d'ions intégré dans l'installation selon la figure 1 ;
La figure 4 est une vue en coupe d'un détail de la figure 3, selon les flèches II-II ; et
La figure 5 est une vue frontale de l'ouverture d'émission du dispositif de la figure 3, selon la flèche III.

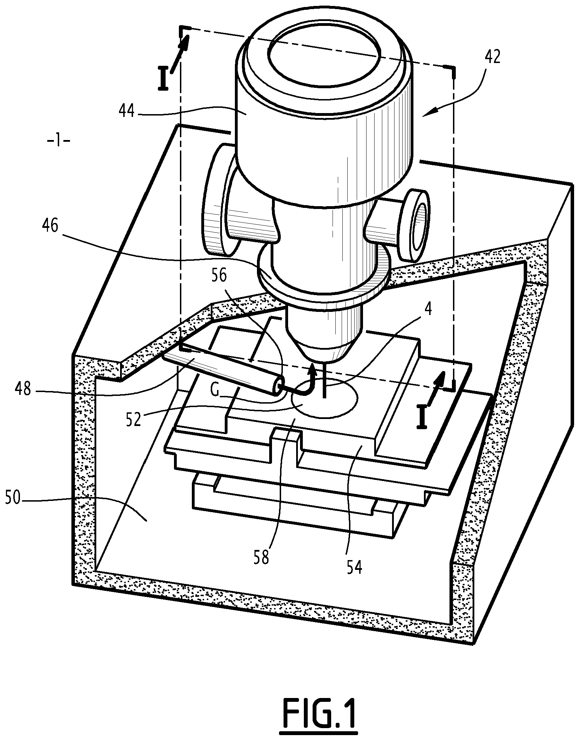

La figure 1 montre une installation 1 à faisceau d'ions focalisé selon l'invention. Cette installation 1 comporte une chambre de travail 50 de forme parallélépipède maintenue sous vide ainsi qu'une colonne 42 de forme généralement cylindrique. La colonne 42 traverse l'une des parois de la chambre de travail 50 et s'étend avec une de ses extrémités à l'intérieur de celle-ci.

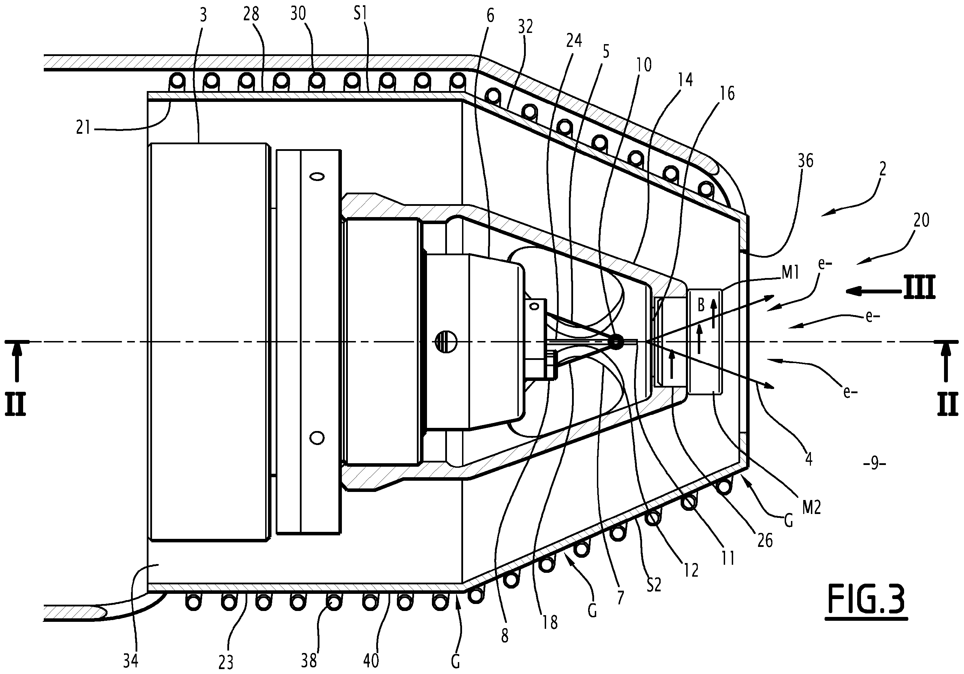

La colonne 42 dispose de plusieurs étages, et notamment d'un premier étage 44 contenant un dispositif 2 de génération d'un faisceau d'ions (cf. la figure 3), et d'un deuxième étage 46 contenant des moyens d'orientation et de focalisation du faisceau d'ions généré à l'intérieur du premier étage.

La chambre de travail 50 contient un support 54 qui sert à tenir et à positionner un échantillon 52 avec une précision nanométrique en trois dimensions. A cet effet, le support 54 comprend de préférence un interféromètre laser.

En outre, la chambre de travail 50 contient une amenée de gaz 48, dont l'ouverture 56 se situe à proximité de la zone de travail 58 du support 54 apte à accueillir un échantillon 52.

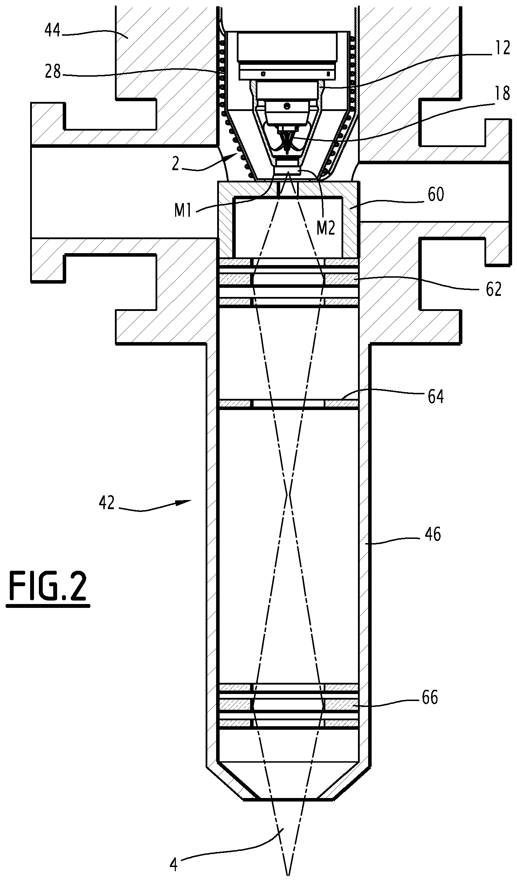

La figure 2 donne un aperçu schématique des éléments principaux présents à l'intérieur de la colonne 42. On distingue, du haut vers le bas, la source d'ions 18, l'électrode d'extraction 12, l'accélérateur 60, une première lentille 62, un diaphragme 64, et une deuxième lentille 66.

La figure 3 illustre un dispositif de génération d'un faisceau d'ions, ce dispositif étant désigné par la référence 2. Ce dispositif 2 se situe à l'intérieur d'un espace 9 du premier étage 44, l'espace étant maintenu sous vide. Le dispositif 2 comprend une source d'ions 18 qui est entourée d'une électrode d'extraction 12. La source d'ions 18 ainsi que l'électrode d'extraction 12 sont fixées sur un support 6. On voit également une embase 3 sur laquelle est montée le support 6.

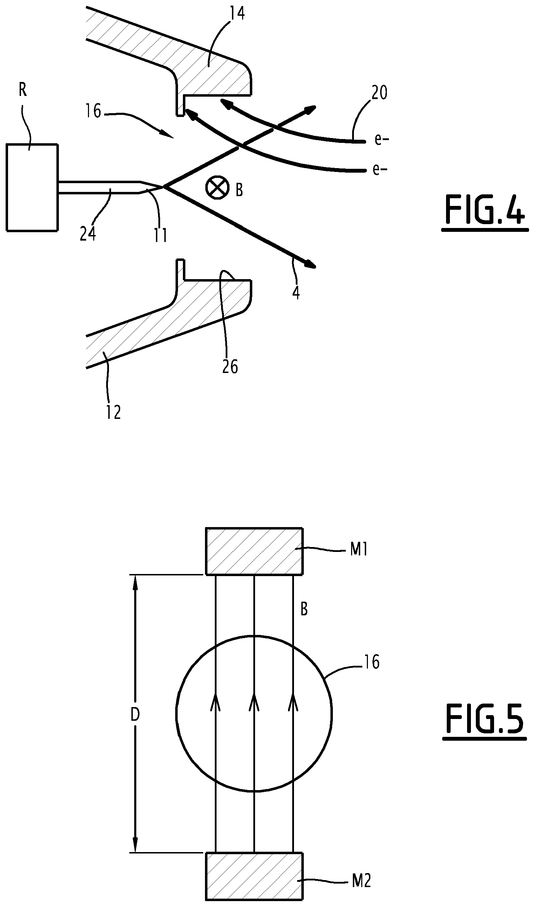

La source 18 comprend une tige conductrice 24 terminée par une pointe 11, un réservoir R (cf. la figure 4) fixé à la tige 24 et servant à accueillir une charge de métal d'apport à liquéfier, ainsi qu'un filament conducteur 5 comportant des enroulements. Ces enroulements sont traversés par la pointe 11 de la tige 24. La tige 24 et le réservoir R sont constitués d'un matériau conducteur et réfractaire, tel que le graphite ou le tungstène. Le métal d'apport est un matériau de haute pureté qui est incorporé à la source d'ions 18 avant son utilisation.

On dénommera « extrémité inférieure » l'extrémité 8 de la source d'ions 18 située à proximité du support 6. L'extrémité 10 de la source d'ions 18 à l'opposé de l'extrémité inférieure 8 sera dénommée « extrémité supérieure ». Cette extrémité supérieure 10 comprend la pointe 11 de la tige 24.

L'électrode d'extraction 12 est pourvue d'une ouverture 16, appelée « diaphragme d'extraction », et d'orifices tels que l'orifice 7, à travers lesquelles peuvent être pompés des gaz résiduels. L'ouverture 16 et lesdits orifices sont réalisés dans une paroi 14 de l'électrode d'extraction 12. L'ouverture 16 se situe au milieu d'un renfoncement cylindrique 26 de l'électrode d'extraction 12.

Les caractéristiques du dispositif 2 qui viennent d'être décrites sont connues, et, pour plus de détails, il est fait référence aux documents WO 02/078036 A2 et WO 96/02065. Par la suite, on s'intéressera aux nouveaux éléments objets de la présente invention.

Le dispositif 2 a la particularité de comprendre un piège cryogénique 28. Le piège 28 doit être suffisamment éloigné de la source d'ions 18 pour éviter un refroidissement du métal d'apport. Ce piège 28 comprend une gaine 32 entourant la source d'ions 18, ainsi que l'électrode d'extraction 12. La gaine 32 présente une section S1 de forme cylindrique et une section S2 de forme tronconique. La paroi de révolution 40 de la gaine 32 forme écran autour de la source d'ions 18. On distingue la surface interne 21 de la paroi 40 qui est tournée vers la source d'ions 18, et la surface externe 23 de la paroi 40 qui est tournée vers l'espace 9. En d'autres termes, la surface externe 23 est située d'un côté de la paroi 40, tandis que la source d'ions 18 est située de l'autre côté de la paroi 40.

La gaine 32 dispose de deux extrémités ouvertes 34 et 36. L'extrémité ouverte 34 permet l'insertion de la source d'ions 18 et de l'électrode d'extraction 12 à l'intérieur de la gaine 32. L'extrémité ouverte 36 permet le passage du faisceau d'ions 4 généré par la source d'ions 18.

Le piège cryogénique 28 comprend en outre un tube spiralé 38 enroulé autour de la gaine 32. Ce tube 38 permet la circulation ou l'accumulation d'un fluide cryogénique 30, de préférence de l'azote liquide.

Une deuxième nouveauté du dispositif 2 est l'ajout d'un filtre magnétique M1, M2. Ce filtre magnétique comprend deux aimants permanents M1 et M2 qui sont disposés en vis-à-vis à l'intérieur du renfoncement 26 de l'électrode d'extraction 12.

En référence à la figure 5, ces deux aimants M1 et M2 définissent entre eux un entrefer D. Cet entrefer D est de préférence ajustable entre environ 2 et 4 mm. Les deux aimants M1 et M2 induisent dans l'entrefer D un champ magnétique B, dont la valeur est de préférence de l'ordre de 0,1 à 1 Tesla. Le champ magnétique B est représenté aux figures 3 à 5 par des lignes de champ fléchées.

La figure 4 est une vue en coupe de la pointe de l'électrode d'extraction 12, selon la ligne II-II de la figure 3. La figure 4 représente donc une vue perpendiculaire à celle représentée par la figure 3. A la figure 4, on distingue le champ magnétique B dont les lignes de champ sont perpendiculaires au plan du dessin. On distingue aussi la pointe 11 de la tige conductrice 24 qui émet le faisceau d'ions 4. Les aimants M1 et M2 ne sont pas visibles à la figure 4 puisqu'ils se situent respectivement à l'arrière et à l'avant du plan du dessin.

La source d'ions 18 est une source d'ions à métal liquide, ou selon son appellation anglaise une « Liquid Metal Ion Source », communément abrégée « LMIS ». Une telle LMIS est apte à générer un faisceau d'ions métalliques, par exemple un faisceau d'ions de gallium ou d'aluminium. Plus précisément, un courant est passé à travers le filament conducteur 5 qui, par effet Joule, chauffe le réservoir R de métal ainsi que la tige 24. La charge de métal présente dans le réservoir R est ainsi liquéfiée et se répand sur la surface de la tige 24, et notamment sur la pointe 11. L'électrode d'extraction 12 arrache des ions métalliques de la couche de métal liquide recouvrant l'apex de la pointe 11.

Les ions métalliques arrachés sont attirés par l'électrode d'extraction 12 et traversent l'ouverture 16. Ils quittent le dispositif 2, puis le premier étage 44, sous forme de faisceau 4. Le faisceau d'ions 4 atteint le deuxième étage 46 pour y être orienté et focalisé sur un échantillon 52 situé à l'intérieur de la chambre de travail 50. Le traitement de la surface de l'échantillon 52 par le faisceau 4 s'effectue par déplacement du support 54. Le faisceau d'ions 4 peut être qualifié de faisceau primaire, et les produits induits par l'utilisation du faisceau 4 sur l'échantillon 52 de sous-produits secondaires.

Le piège cryogénique 28 a été ajouté au dispositif 2 afin de le rendre compatible avec les techniques d'injection de gaz fréquemment utilisées dans des applications industrielles de dispositifs de génération d'ions. Ces techniques d'injection consistent à introduire des gaz réactifs ou précurseurs dans la chambre de travail 50 à l'aide d'une ou plusieurs amenées de gaz, tel que l'amenée 48, afin de diversifier ou d'améliorer et d'accélérer le traitement des échantillons 52 par le faisceau d'ions 4.

Une première de ces techniques est déployée lorsque le faisceau d'ions 4 est utilisé pour graver un échantillon. Des gaz réactifs sont acheminés par l'amenée 48 et la quitte en direction de l'échantillon 52. Les gaz réagissent avec les atomes de l'échantillon 52 pulvérisés par le faisceau 4 en formant des composés volatils. Les composés volatils sont évacués par le système de pompage de la chambre de travail 50. Ce procédé améliore la vitesse de gravure car il neutralise et évacue les déblais issus de la gravure.

La technique d'injection s'utilise aussi pour déposer des substances sur un échantillon. A cet effet, on introduit par l'amenée 48 des gaz précurseurs dans la chambre de travail 50 dont les molécules sont dissociées par l'action du faisceau d'ions 4. Les composés non volatils de cette réaction forment alors un dépôt solide adhérant à la surface de l'échantillon 52.

Dans le contexte d'une source d'ions à métal liquide, ces techniques d'injection présentent un inconvénient majeur. En effet, les gaz injectés dans la chambre de travail 50 diffusent à l'intérieur de celle-ci et pénètrent dans la colonne 42. A cause d'un gradient de pression favorable (le vide à l'intérieur du premier étage 44 est plus poussé que le vide au sein de la chambre de travail 50), ces gaz s'acheminent jusqu'à la source 18 et interagissent avec le métal liquide. Ces interactions ont des effets extrêmement néfastes sur la source d'ions 18, et la déstabilisent. Ainsi, Il devient impossible de maintenir la stabilité de l'émission d'ions sur des périodes de plusieurs heures.

Le piège cryogénique 28 permet de résoudre ce problème en protégeant la source d'ions 18 des vapeurs de gaz injecté. Le métal d'apport liquide est ainsi préservé. Grâce à son piège cryogénique, le dispositif 2 de génération de faisceau d'ions est compatible avec les techniques d'injection de gaz.

Le piège cryogénique 28 fonctionne de la manière suivante. On fait circuler de l'azote liquide 30 à l'intérieur du tube 38 afin de refroidir la paroi 40 de la gaine 32 à une température en dessous de 100 K. La gaine 32 ainsi refroidie constitue un piège pour les vapeurs de gaz injecté G, qui sont représentées aux figures 1 et 3 par des flèches ondulées. Ces espèces volatiles G entrent dans la colonne 42, traversent le deuxième étage 46 et atteignent le premier étage 44 pour ensuite se répandre dans l'espace 9 autour du dispositif 2 de génération d'un faisceau d'ions. Les vapeurs G sont arrêtées sur leur trajet vers la source d'ions 18 par la surface externe 23 de la paroi 40 qui forme barrage. Une fois arrêtées par la surface externe 23, les espèces G se refroidissent rapidement et perdent donc une grande partie de leur énergie cinétique. Les espèces G se condensent sur la surface externe 23 et se trouvent réellement « piégées ». Par manque d'énergie, elles restent « collées » au piège cryogénique 28 et ne peuvent donc plus atteindre la source d'ions 18.

Selon une variante de l'invention, le piège cryogénique comprend comme moyen de refroidissement un cryogénérateur/réfrigérateur mécanique ou bien un réfrigérateur électrique, de préférence un dispositif à effet dit « Peltier », au lieu d'un fluide cryogénique.

Le filtre magnétique M1, M2 a été ajouté au dispositif 2 afin d'empêcher les électrons secondaires 20 (cf. les figures 3 et 4) d'atteindre la source d'ions 18. Ces électrons secondaires 20 sont crées par l'impact d'ions du faisceau d'ions 4 sur les parois de l'environnement du dispositif 2. Ils sont attirés par le champ électrique local de forte intensité existant autour de la pointe 11. En absence du champ magnétique B, les électrons secondaires 20 pénètrent à l'intérieur de l'électrode d'extraction 12 par l'ouverture 16 et contaminent la source d'ions 18.

Grâce au champ magnétique B au niveau de l'ouverture 16, les électrons secondaires 20 sont déviés de leur trajectoire, tel qu'on peut le voir à la figure 4, et sont interceptés par la paroi 14 de l'électrode d'extraction 12 elle-même générant un champ électrostatique attracteur. Les électrons secondaires 20 sont ainsi neutralisés. Le filtre magnétique M1, M2 protège donc le métal liquide de la source d'ions 18 des électrons secondaires.

En revanche, l'influence du champ magnétique B sur la trajectoire des ions métalliques en provenance de la pointe 11 de la tige 24 à travers l'ouverture 16 est négligeable En effet, les ions métalliques disposent d'une masse et d'une énergie cinétique beaucoup plus élevées que les électrons secondaires. Ainsi, même en présence du champ magnétique B, la trajectoire des ions métalliques reste essentiellement inchangée.

Il convient de noter que le filtre magnétique selon l'invention peut aussi prendre d'autres formes que celle qui vient d'être décrite. En effet, pour atteindre le but recherché, il suffit d'un moyen quelconque, du moment qu'il soit apte à générer un champ magnétique adapté pour empêcher les électrons secondaires d'atteindre la source d'ions 18.

Le dispositif de génération d'un faisceau d'ions selon l'invention présente en particulier les avantages suivants :
- un fonctionnement plus stable de la source d'ions à faible courant d'émission (< 3 µA) grâce à l'élimination du courant d'électrons secondaires venant frapper la pointe émettrice ;
- une augmentation de la durée de vie de la source ;
- une meilleure pureté du faisceau d'ions émis par une protection accrue de la source ; et
- l'obtention d'un effet de pompage plus efficace dans la région de la source d'ions permettant de maintenir la source en émission dans un vide poussé (10 - 8 mbar) et ainsi de « gommer » l'influence des fluctuations de vide liées aux chargements et déchargements des échantillons qui pourront ainsi être multipliés à volonté sans endommager la source d'ions pouvant être laissée en fonctionnement.

En résumé, ce dispositif permet de préserver l'intégrité de la source d'ions et par voie de conséquence d'espacer le nombre et la fréquence (i) des opérations de décontamination généralement effectuées par un chauffage de la source lesquelles nécessitent d'interrompre l'utilisation, impliquent un nouveau réglage de l'instrument et induisent une perte par évaporation du métal liquide et (ii) de remplacements des sources arrivées en fin de vie.

L'invention permet d'améliorer la productivité du dispositif, l'utilisateur pouvant conserver les réglages opératoires (centrage optique de la source d'ions par rapport au système d'optique électrostatique, focalisation et correction de l'astigmatisme résiduel du faisceau) pendant des durées considérablement augmentées.

## Revendications

1. Dispositif (2) de génération d'un faisceau d'ions (4) comportant une source d'ions (18) à métal liquide, **caractérisé en ce que** la source d'ions est entourée d'un piège cryogénique (28) maintenu à basse température, ce piège cryogénique étant apte à piéger des espèces chimiques volatiles (G) par condensation avant qu'elles ne puissent atteindre la source d'ions.

2. Dispositif selon la revendication 1, dans lequel le piège cryogénique (28) est maintenu à basse température par:
- circulation ou accumulation d'un fluide cryogénique (30), le fluide cryogénique étant de préférence de l'azote liquide ; ou
- un réfrigérateur mécanique générant une faible émission de vibrations ; ou
- un réfrigérateur électrique.

3. Dispositif selon la revendication 1 ou 2, dans lequel le piège cryogénique est maintenu à une température inférieure à 100 K.

4. Dispositif selon l'une quelconque des revendications précédentes, dans lequel le piège cryogénique comprend une gaine (32) à deux extrémités ouvertes (34, 36) entourant la source d'ions (18).

5. Dispositif selon la revendication 4, dans lequel le piège cryogénique comprend un tube spiralé (38) à fluide cryogénique (30) enroulé autour de la gaine (32).

6. Dispositif selon la revendication 4 ou 5, dans lequel l'une (36) des extrémités ouvertes de la gaine (32) sert au passage du faisceau d'ions (4) produit par la source d'ions.

7. Dispositif selon l'une quelconque des revendications 4 à 6, dans lequel la gaine est formé par une paroi de révolution (40), cette paroi comprenant une première section (S1) de forme cylindrique et une deuxième section (S2) de forme tronconique.

8. Dispositif selon l'une quelconque des revendications précédentes, le dispositif comprenant en outre une électrode d'extraction (12), le piège cryogénique entourant à la fois la source d'ions et l'électrode d'extraction.

9. Dispositif selon la revendication 8, dans lequel, l'électrode d'extraction (12) étant munie d'une ouverture (16) permettant le passage du faisceau d'ions (4), le dispositif comprend en outre un moyen (M1, M2) de génération d'un champ magnétique (B) apte à générer un champ magnétique (B) au niveau de l'ouverture (16) de l'électrode d'extraction (12), le champ magnétique (B) généré étant apte à dévier des particules chargées (20) attirées par la source d'ions de manière à ce que ces particules chargées n'atteignent pas la source d'ions.

10. Dispositif selon la revendication 9, dans lequel le champ magnétique (B) généré est apte à dévier les particules chargées (20) de telle manière qu'elles rencontrent une paroi (14) de l'électrode d'extraction au lieu d'atteindre, en traversant l'ouverture (16) de l'électrode d'extraction, la source d'ions (18).

11. Dispositif selon la revendication 9 ou 10, dans lequel le moyen (M1, M2) de génération d'un champ magnétique est agencé au niveau de l'ouverture (16) de l'électrode d'extraction.

12. Dispositif selon la revendication 11, dans lequel l'ouverture (16) de l'électrode d'extraction est réalisée dans un renfoncement (26) de l'électrode d'extraction, le moyen (M1, M2) de génération d'un champ magnétique étant placé à l'intérieur de ce renfoncement, en bordure de ladite ouverture (16).

13. Dispositif selon l'une quelconque des revendications 9 à 12, dans lequel le moyen de génération d'un champ magnétique comprend au moins un aimant permanent (M1, M2).

14. Dispositif selon la revendication 13, dans lequel le moyen de génération d'un champ magnétique est composé de deux aimants permanents (M1, M2) placés en vis-à-vis.

15. Dispositif selon la revendication 14, dans lequel les deux aimants permanents (M1, M2) définissent entre eux un entrefer (D) de préférence ajustable d'environ 2 à environ 4 mm.

16. Dispositif selon la revendication 15, dans lequel le champ magnétique (B) induit par les deux aimants permanents (M1, M2) dans l'entrefer (D) est de l'ordre de 0,1 à 1 Tesla.

17. Dispositif selon l'une quelconque des revendications précédentes, dans lequel la source d'ions (18) à métal liquide comprend une tige conductrice (24) terminée par une pointe (11), un réservoir (R) fixé à la tige (24) et servant à accueillir une charge de métal à liquéfier, ainsi qu'un filament conducteur (5) comportant des enroulements traversés par la pointe (11) de la tige (24).

18. Installation (1) à faisceau d'ions focalisé comprenant :
- une chambre de travail (50) contenant un support (54) d'échantillon et une amenée (48) de gaz réactifs à proximité du support (54) d'échantillon ; et
- une colonne (42) à plusieurs étages, dont un premier étage (44) de génération du faisceau d'ions et un deuxième étage (46) d'orientation et de focalisation du faisceau d'ions,
installation dans laquelle le premier étage (44) comporte un dispositif selon l'une quelconque des revendications précédentes.

## Patentansprüche

1. Vorrichtung (2) zur Erzeugung eines Ionenstrahls (4), aufweisend eine Ionenquelle (18) mit Flüssigmetall, **dadurch gekennzeichnet, dass** die Ionenquelle von einer Kryogen-Falle (28) umgeben ist, die auf einer tiefen Temperatur gehalten wird, wobei die Kryogen-Falle imstande ist, flüchtige chemische Stoffe (G) durch Kondensation zu fangen, bevor diese die Ionenquelle erreichen können.

2. Vorrichtung gemäß Anspruch 1, wobei die Kryogen-Falle (28) auf tiefer Temperatur gehalten wird durch:
- Zirkulation oder Akkumulation eines Kryogen-Fluid (30), wobei das Kryogen-Fluid bevorzugt flüssiger Stickstoff ist, oder
- eine mechanische Kühlvorrichtung, die eine schwache Emission von Vibrationen erzeugt, oder
- eine elektrische Kühlvorrichtung.

3. Vorrichtung gemäß Anspruch 1 oder 2, wobei die Kryogen-Falle auf einer Temperatur kleiner als 100 K gehalten wird.

4. Vorrichtung gemäß irgendeinem der vorhergehenden Ansprüche, wobei die Kryogen-Falle aufweist eine Hülle (32) mit zwei offenen Enden (34, 36), die die Ionenquelle (18) umgibt.

5. Vorrichtung gemäß Anspruch 4, wobei die Kryogen-Falle ein wendelförmiges Rohr (38) mit Kryogen-Fluid (30) aufweist, das um die Hülle (32) gewunden ist.

6. Vorrichtung gemäß Anspruch 4 oder 5, wobei eines (36) der offenen Enden der Hülle (32) dem Durchgang des Ionenstrahls (4) dient, der von der Ionenquelle erzeugt wird.

7. Vorrichtung gemäß irgendeinem der Ansprüche 4 bis 6, wobei die Hülle von einer Umfangswand (40) gebildet ist, wobei diese Wand einen ersten Abschnitt (S1) von zylindrischer Form und einen zweiten Abschnitt (S2) von konischer Form aufweist.

8. Vorrichtung gemäß irgendeinem der vorhergehenden Ansprüche, wobei die Vorrichtung ferner eine Extraktions-Elektrode (12) aufweist, wobei die Kryogen-Falle sowohl die Ionenquelle als auch die Extraktions-Elektrode umgibt.

9. Vorrichtung gemäß Anspruch 8, wobei die Extraktions-Elektrode (12) mit einer Öffnung (16) versehen ist, welche den Durchgang des Ionenstrahls (4) erlaubt, wobei die Vorrichtung ferner ein Mittel (M1, M2) zur Erzeugung eines magnetischen Felds (B) aufweist, das in der Lage ist, ein magnetisches Feld (B) auf Höhe der Öffnung (16) der Extraktions-Elektrode (12) zu erzeugen, wobei das erzeugte magnetische Feld (B) in der Lage ist, geladene Partikel (20) umzulenken, die von der Ionenquelle angezogen werden, sodass diese geladenen Partikel die Ionenquelle nicht erreichen.

10. Vorrichtung gemäß Anspruch 9, wobei das erzeugte magnetische Feld (B) in der Lage ist, die geladenen Partikel (20) derart umzulenken, dass sie auf eine Wand (14) der Extraktions-Elektrode auftreffen, anstatt unter Durchqueren der Öffnung (16) der Extraktions-Elektrode die Ionenquelle (18) zu erreichen.

11. Vorrichtung gemäß Anspruch 9 oder 10, wobei das Mittel (M1, M2) zur Erzeugung eines magnetischen Felds auf Höhe der Öffnung (16) der Extraktions-Elektrode angeordnet ist.

12. Vorrichtung gemäß Anspruch 11, wobei die Öffnung (16) der Extraktions-Elektrode in einer Vertiefung (26) der Extraktions-Elektrode realisiert ist, wobei das Mittel (M1, M2) zur Erzeugung eines magnetischen Felds im Innern dieser Vertiefung am Rand der besagten Öffnung (16) platziert ist.

13. Vorrichtung gemäß irgendeinem der Ansprüche 9 bis 12, wobei das Mittel zur Erzeugung eines magnetischen Felds wenigstens einen Permanent-Magneten (M1, M2) aufweist.

14. Vorrichtung gemäß Anspruch 13, wobei das Mittel zur Erzeugung eines magnetischen Felds zusammengesetzt ist aus zwei Permanent-Magneten (M1, M2), die einander gegenüberliegend platziert sind.

15. Vorrichtung gemäß Anspruch 14, wobei die beiden Permanentmagnete (M1, M2) zwischen sich einen Luftspalt (D) definieren, der bevorzugt einstellbar ist von etwa 2 bis etwa 4 mm.

16. Vorrichtung gemäß Anspruch 15, wobei das magnetische Feld (B), das von den beiden Permanent-Magneten (M1, M2) in dem Luftspalt (D) induziert wird, etwa 0,1 bis 1 Tesla hat.

17. Vorrichtung gemäß irgendeinem der vorhergehenden Ansprüche, wobei die Ionenquelle (18) mit Flüssigmetall aufweist eine leitfähige Stange (24), die in einer Spitze (11) endet, ein Behältnis (R), das an der Stange (24) fixiert ist und das dazu dient, eine Charge von zu verflüssigendem Metall aufzunehmen, sowie einen leitfähigen Faden (5), der Wicklungen aufweist, die von der Spitze (11) der Stange (24) durchquert sind.

18. Fokussierter-Ionenstrahl-Einrichtung (1), aufweisend:
- eine Arbeitskammer (50), die eine Halterung (54) für eine Probe und eine Zuleitung (48) für Reaktionsgas in der Nähe der Halterung (54) für eine Probe aufweist, und
- eine Säule (429 mit mehreren Etagen, darunter eine erste Etage (44) zur Erzeugung des Ionenstrahls und eine zweite Etage (46) zur Ausrichtung und zur Fokussierung des Ionenstrahls,
wobei bei der Einrichtung die erste Etage (44) eine Vorrichtung gemäß irgendeinem der vorhergehenden Ansprüche aufweist.

## Claims

1. A device (2) for generating an ion beam (4) including a liquid metal ion source (18), **characterized in that** the ion source is surrounded by a cryogenic trap (28) maintained at a low temperature, this cryogenic trap being able to trap volatile chemical species (G) by condensing them before they can reach the ion source.

2. The device according to claim 1, wherein the cryogenic trap (28) is maintained at a low temperature by:
- circulation or accumulation of a cryogenic fluid (30), the cryogenic fluid preferably being liquid nitrogen; or
- a mechanical refrigerator generating a low vibration emission; or
- an electric refrigerator.

3. The device according to claim 1 or 2, wherein the cryogenic trap is maintained at a temperature below 100 K.

4. The device according to any one of the preceding claims, wherein the cryogenic trap comprises a sheath (32) with two open ends (34, 36) surrounding the ion source (18).

5. The device according to claim 4, wherein the cryogenic trap comprises a spiraled cryogenic fluid (30) tube (38) wound around the sheath (32).

6. The device according to claim 4 or 5, wherein one (36) of the open ends of the sheath (32) is used for the passage of the ion beam (4) produced by the ion source.

7. The device according to any one of claims 4 to 6, wherein the sheath is formed by a rotating wall (40), said wall comprising a first cylindrical section (S1) and a second tapered section (S2).

8. The device according to any one of the preceding claims, the device also including an extraction electrode (12), the cryogenic trap surrounding both the ion source and the extraction electrode.

9. The device according to claim 8, where, the extraction electrode (12) being provided with an opening (16) allowing the passage of the ion beam (4), the device also comprises a means (M1, M2) for generating a magnetic field (B) able to generate a magnetic field (B) at the opening (16) of the extraction electrode (12), the generated magnetic field (B) being able to deviate charged particles (20) attracted by the ion source so that these charged particles do not reach the ion source.

10. The device according to claim 8, wherein the generated magnetic field (B) is able to deviate the charged particles (20) so that they encounter a wall (14) of the extraction electrode instead of reaching, by passing through the opening (16) of the extraction electrode, the ion source (18).

11. The device according to claim 9 or 10, wherein the means (M1, M2) for generating a magnetic field is arranged at the opening (16) of the extraction electrode.

12. The device according to claim 11, wherein the opening (16) for the extraction electrode is made in a recess (26) of the extraction electrode, the means (M1, M2) for generating a magnetic field being placed inside that recess, on the edge of said opening (16).

13. The device according to any one of claims 9 to 12, wherein the means for generating a magnetic field comprises at least one permanent magnet (M1, M2).

14. The device according to claim 13, wherein the means for generating a magnetic field is made up of two permanent magnets (M1, M2) placed opposite each other.

15. The device according to claim 14, wherein the two permanent magnets (M1, M2) define an air gap (D) between them, which is preferably adjustable from about 2 to about 4 mm.

16. The device according to claim 15, wherein the magnetic field (B) induced by the two permanent magnets (M1, M2) in the air gap (D) is in the vicinity of 0.1 to 1 Tesla.

17. The device according to any one of the preceding claims, wherein the liquid metal ion source (18) comprises a conductive rod (24) ending with a needle (11), a container (R) fixed to the rod (24) and serving to receive a metal charge to be liquefied, as well as a conductive filament (5) comprising coils passed through by the needle (11) of the rod (24).

18. A focused ion beam installation (1) comprising:
- a work chamber (50) containing a sample holder (54) and a reactive gas inlet (48) near the sample holder (54); and
- a column (42) with several levels, including a first level (44) for generating the ion beam and a second level (46) for orienting and focusing the ion beam,
in which installation the first level (44) includes a device for generating an ion beam according to any one of the preceding claims.
